# EUROPÄISCHE PATENTSCHRIFT

(11) **EP 1 115 897 B1**
(45) Veröffentlichungstag und Bekanntmachung des Hinweises auf die Patenterteilung: **06.10.2004**
(21) Anmeldenummer: 99945891.2
(22) Anmeldetag: 02.07.1999
(51) Int. Cl.: C23C 14/02, H01F 41/02

(54) **VERFAHREN ZUR VERBESSERUNG DES KORROSIONSSCHUTZES VON SELTENERDDAUERMAGNETEN**
METHOD FOR IMPROVING THE CORROSION PROTECTION OF PERMANENT MAGNETS CONTAINING RARE EARTH METALS
PROCEDE POUR AMELIORER LA PROTECTION ANTICORROSION D'AIMANTS PERMANENTS CONTENANT DES METAUX DES TERRES RARES

(30) Priorität: 17.07.1998 DE 19832299
(43) Veröffentlichungstag der Anmeldung: 18.07.2001
(73) Patentinhaber: Vacuumschmelze GmbH, 63450 Hanau (DE)
(72) Erfinder: STAUBACH, Harald, D-63755 Alzenau (DE); ZAPF, Lothar, D-63755 Alzenau (DE)
(74) Vertreter: Schmuckermaier, Bernhard
(86) Internationale Anmeldenummer: PCT/DE1999/002045
(87) Internationale Veröffentlichungsnummer: WO 2000/004201

(56) Entgegenhaltungen:
- EP-A- 0 345 092
- EP-A- 0 430 198
- EP-A- 0 794 268
- US-A- 4 837 114
- "PRETREATMENT PROCESS FOR ORGANIC COATING OR NEODYMIUM-IRON-BORON MAGNETS" IBM TECHNICAL DISCLOSURE BULLETIN,US,IBM CORP. NEW YORK, Bd. 32, Nr. 9A, Seite 83 XP000082999 ISSN: 0018-8689

## Beschreibung

Die Erfindung betrifft ein Verfahren zur Herstellung eines Sintermaterials, vorzugsweise eines Magnetkörpers, mit verbessertem Korrosionsschutz durch Beschichtung mit einem Metall und anschließender Wärmebehandlung.

Magnete, welche Seltene Erden enthalten, wie z. B. Nd-Fe-B-Magnete, werden zur Vermeidung bzw. Verminderung von Korrosion durch Beschichtung mit einem Metall geschützt. Wurden früher noch Lackierungen zur Verringerung der Korrosion auf die Magnete aufgebracht, werden heute vorwiegend Metallbeschichtungen auf Basis von Nickel, Zinn, Cadmium oder Aluminium zur Korrosionsverminderung verwendet.

Es hat sich gezeigt, daß ein für viele Anwendungen bereits ausreichender Korrosionsschutz von Nd-Fe-B-Magnete in salzhaltiger Umgebung oder in einer Atmosphäre mit hoher Luftfeuchtigkeit mit einer Metallbeschichtung auf Aluminium Basis erreicht werden kann.

Beispielsweise ist aus Modern Magnetic Mat. Conference Proceedings, London, 20-21, Juni 1989, Seite 8.2 bis 8.2.8, ein Verfahren zur Aluminiumbeschichtung von Nd-Fe-B-Magneten nach dem IVD (Ion Vapor Deposition)-Verfahren bekannt. Gemäß dieser Druckschrift werden die Magnete zunächst zur Reinigung sandgestrahlt und anschließend in der für das IVD-Verfahren verwendeten Vakuumkammer mit Argonionen bombardiert. Hierdurch erreicht man eine verbesserte Haftung des IVD-Aluminiums auf der Oberfläche, wodurch die Korrosionsbeständigkeit des Magneten verbessert wird.

Aus der EP-A-0 794 268 geht ebenfalls ein Verfahren zur Beschichtung von Nd-Fe-B-Magenten mit Aluminium hervor. Nach dieser Schrift kann eine weitere Verbesserung der Korrosionsbeständigkeit durch eine an den vorstehenden Prozeß anschließende Wärmebehandlung bei einer Temperatur von mindestens 400°C erzielt werden. Nach diesem Verfahren hergestellte Magnete weisen eine Korrosionsbeständigkeit, gemessen nach dem HAST-Test (HAST = highly accelerated steam test) bei 130°C und einem Druck von 2,7 bar, von 100 Stunden auf.

Obwohl das vorstehend beschriebene Verfahren bereits zu einer für viele Anwendungen ausreichenden Korrosionsbeständigkeit der Dauermagnete führt, ist besonders bei hohen thermischen oder chemischen Belastungen bzw. unter agressiven Bedingungen die Korrosionsbeständigkeit der Dauermagnete noch nicht ausreichend. Es besteht daher ein Bedarf an einer weiteren Verbesserung der Korrosionsbeständigkeit von Seltenerddauermagneten.

Aufgabe der vorliegenden Erfindung ist es daher, ein Verfahren zur Verfügung zu stellen, welches zu beschichteten Magnetkörpern führt, welche gegenüber bekannten Magnetkörpern eine verbesserte Korrosionsbeständigkeit aufweisen.

Eine weitere Aufgabe der Erfindung ist die Bereitstellung eines Verfahrens zur Beschichtung, welches ohne die Notwendigkeit einer vor der Auftragung der Metallschicht stattfindenden Behandlung der Oberfläche des Dauermagneten mit einer mechanischen Strahlerrosion, wie beispielsweise Sandstrahlen oder Strahlen mit Korrund, auskommt.

Die erfindungsgemäße Aufgabe wird gelöst durch ein Verfahren zur Herstellung eines Sintermaterials mit verbessertem Korrosionsschutz durch Aktivierung der Oberfläche und anschließende Beschichtung der Oberfläche mit einem Metall und daran anschließender Wärmebehandlung, welches dadurch gekennzeichnet ist, daß während der Aktivierung vor Beschichtung der Oberfläche die Schritte
- Entfernung von auf der Oberfläche des Sintermaterials anhaftender Partikel mittels Behandlung der Oberfläche mit einem Beizmittel,
- Passivierung der Oberfläche durch mindestens einen der Schritte aus der Gruppe a) Behandlung mit einem hydrophilen Lösungsmittel, b) Behandlung mit einer Phosphatierungslösung, c) Behandlung mit einer Chromatierungslösung, d) Behandlung mit einer Flüssigkeit zur Dehydratisierung (Dewatering) der Oberfläche oder e) Temperaturbehandlung des Sintermaterials und
- Trocknung des Sintermaterials durchgeführt werden.

Erfindungsgemäß erfolgt die Entfernung von auf der Oberfläche des Sintermaterials anhaftender unerwünschter Partikel (z.B. Oxide oder auch anhaftender Magnetstaub), welche, wie sich gezeigt hat, die Haftung der Korrosionsschicht und deren korrosionsschützende Eigenschaft drastisch vermindern, durch Beizen der Oberfläche. Diese Methode zur Vorbehandlung der Oberfläche vor der Beschichtung liefert bezüglich der Korrosionsbeständigkeit verbesserte Ergebnisse. Es ist daher im allgemeinen nicht nötig, andere im Stand der Technik bekannte Methoden zur Oberflächenaktivierung durchzuführen. So kann vorzugsweise ganz auf eine Aktivierung des Sintermaterials bzw. Entfernung von Verunreinigungen vor der Beschichtung mittels einer Einrichtung zur mechanischen Strahlerrosion, wie zum Beispiel Sandstrahlen oder Korundstrahlen, verzichtet werden.

Unter den vorstehend erwähnten Verunreinigungen werden Schmutzpartikel, Oxidmaterial oder sonstige Materialien auf der Oberfläche des Sinterkörpers verstanden, welche die Haftung oder Korrosionsbeständigkeit des Magnetkörpers verschlechtern können.

Gemäß der Erfindung wird die Oberfläche aktiviert durch Beizen, Passivieren und Trocknen. Das Beizmittel, welches zur Entfernung von anhaftenden Partikeln verwendet wird, enthält vorzugsweise eine Säure.

Wird zum Beizen eine Säure eingesetzt, so sind Säuren, die in in wässriger Lösung vorliegen bevorzugt. Beispiele für geeignete Säuren sind Salpetersäure, salpetrige Säuren, Peroxid-Schwefelsäuren oder Peroxid-Salpetersäuregemische. Besonders bevorzugt ist das Beizmittel eine Lösung mit einem Säureanteil in einem Bereich von 0,2 bis 25 Gew.-%, insbesondere 1 bis 15 Gew.-%. Ganz besonders bevorzugt ist das Beizmittel eine Salpetersäure in 8 bis 15%iger wässriger Lösung.

Vor dem Beizschritt kann das Sintermaterial noch auf an sich bekannte Weise vorgereinigt werden, beispielsweise durch Reinigen in einem Ultraschallbad mit einer geeigneten entfettenden Reinigungsflüssigkeit. Die Vorreinigung erfolgt zweckmäßigerweise bei erhöhter Temperatur, beispielsweise in einer kochenden Entfettungslösung. Nach der Vorreinigung oder auch nach dem Beizen ist eine zusätzlicher Spülschritt, welcher beispielsweise durch Spülen mit Wasser erfolgen kann, bevorzugt.

Die Passivierung des Sintermaterials erfolgt gemäß der Erfindung durch mindestens einen der Schritte
a) Behandlung mit einem hydrophilen Lösungsmittel,
b) Behandlung einer Phosphatierungslösung,
c) Behandlung mit einer Chromatierungslösungen,
d) Behandlung mit einer Flüssigkeit zur Dehydratisierung (Dewatering) der Oberfläche oder
e) Temperaturbehandlung des Sintermaterials.

Beispiele für hydrophile bzw. wassermischbare Lösungsmittel sind Alkohole, γ-Butyrolacton, Aceton, Glykoletheralkohole und N-Methylpyrolidon.

Ein Beispiel für eine Phosphatierungslösung ist ®Granodine 20, Fa. Henkel.

Ein Beispiel für eine Chromatierungslösung ist ®Immunox Gelb Zn, Fa. Blasberg.

Flüssigkeiten zur Dehydratisierung sind an sich bekannt und arbeiten nach dem Prinzip der hydraulischen Verdrängung. Ein Beispiel für eine Flüssigkeit zur Dehydratisierung ist ein Mineralöl oder ein Kohlenwasserstoffgemisch mit wasserverdrängenden Eigenschaften, z. B. Safecoat der Fa. Castrol.

Wird die Oberfläche chemisch passiviert, was beispielsweise durch Chromatierung oder Phosphatierung erfolgen kann, so ist es bevorzugt, im Anschluß an die Passivierung noch einen Spülschritt mit Wasser einzufügen.

Im Anschluß an die Passivierung wird das Sintermaterial getrocknet. Vorzugweise erfolgt die Trocknung unmittelbar nach dem Passivierungsschritt.

Die Trocknung des Sintermaterials kann auf an sich bekannte Weise erfolgen, beispielsweise durch Trocknung mit Heißluft, Vakuumtrocknung oder Zentrifugieren.

Nach der Trocknung der Oberfläche des Sintermaterials wird die Oberfläche auf an sich bekannte Weise mit einem Metall beschichtet. Es ist in diesem Zusammenhang überaus überraschend, daß die erfindungsgemäß vorbehandelten Sinterkörper vor der Beschichtung ohne Einbußen an die Korrosionsbeständigkeit für längere Zeit, beispielsweise für mehrere Wochen, gelagert werden können.

Die Metallschicht wird vorzugsweise nach einem physikalischen-Dampf-Abscheidungsverfahren (PVD), insbesondere durch Ionen-Dampfabscheidung (IVD), aufgebracht.

Beschichtungsmethoden nach dem IVD-Verfahren sind beispielsweise aus Modern Magnetic Mat. Conference Proceedings, London, 20-21, Juni 1989, Seite 8.2 bis 8.2.8 und der EP-A-0 794 268 bekannt.

Üblicherweise werden während des IVD-Verfahrens die Sinterkörper unmittelbar vor der Beschichtung in der zur Beschichtung verwendeten Vakuumkammer unter Verwendung von ionisiertem Argon gereinigt. Dann wird innerhalb der Kammer das abzuscheidende Metall kontinuierlich verdampft.

Es hat sich überraschenderweise gezeigt, daß die Reinigung der Oberfläche, welche nach bekannten Verfahren mit Hilfe von ionisiertem Argon durchgeführt wird, durch die erfindungsgemäße Vorbehandlung noch weiter verbessert werden kann.

Die auf die Oberfläche aufgebrachte Metallschicht besteht bevorzugt zu mindestens 75 Gew.-% aus Al. Besonders bevorzugt besteht die metallische Oberfläche ganz aus Al.

Die aufgebrachte Metallschicht läßt sich im Anschluß an die Beschichtung noch weiter verdichten. Vorzugsweise wird daher noch ein mechanischer Verdichtungsschritt, welcher insbesondere darin bestehen kann, daß Glaskugeln oder -perlen auf die Oberfläche des Sinterkörpers gestrahlt werden, durchgeführt.

Nach der Beschichtung kann der Korrossionsschutz durch eine an sich bekannte Wärmebehandlung verbessert werden. Eine entsprechende Wärmebehandlung, welche bei einer Temperatur von mindestens 400°C durchgeführt wird, ist daher bevorzugt. Die Dauer der Wärmebehandlung beträgt vorzugsweise mindestens 30 Minuten. Sie wird zweckmäßigerweise in einer Atmosphäre aus *Luft, Vakuum* oder unter Schutzgas durchgeführt

Durch das erfindungsgemäße Verfahren lassen sich Magnetkörper mit verbesserten korrosionshemmenden Eigenschaften herstellen. Die Erfindung führt daher zu einem Magnetkörper enthaltend seltende Erden mit einer auf der Oberfläche aufgebrachten korrosionshemmenden Schicht, welche im wesentlichen ein Metall enthält. Ein solcher Magnetkörper zeichnet sich dadurch aus, daß die Korrosionsbeständigkeit, gemessen nach dem HAST-Test mindestens 50 Stunden, vorzugsweise 150 Stunden, bei einer Schichtdicke von weniger als 40 µm beträgt, wobei der HAST-Test in einer gesättigten Wasserdampfatmosphäre bei einer Temperatur von 130°C und einem Druck von 2,7 bar durchgeführt wird und der Test als bestanden gilt, wenn sich innerhalb des vorstehend angegebenen Zeitraums keine Korrosionserscheinungen, wie Blasen oder Schichtdelaminationsbereiche bilden.

Die Dicke der korrosionshemmenden Schicht des Magnetkörpers liegt vorzugsweise in einem Bereich unterhalb 25 µm. Als untere Grenze ist eine Dicke der Schicht von 1 µm bevorzugt.

Vorzugsweise besteht die korrosionshemmende Schicht des Magnetkörpers zu mindestens 75 Gew.-% aus Al.

Der Korrosionsschutz der erfindungsgemäßen Beschichtung ist überraschend hoch. Die Ergebnisse bekannter Beschichtungen werden übertroffen. Es ist daher für viele Anwendungen vollkommen ausreichend, wenn nur eine einzige korrosionshemmende Schicht aufgetragen ist. Daher sind Sintermaterialen mit nur einer korrosionshemmenden Schicht auf der Oberfläche des Magnetkörpers bevorzugt.

Vorzugsweise wird die metallische Oberfläche der korrosionshemmenden Schicht chromatiert.

Als Material für den Magnetkörper oder als Sintermaterial lassen sich erfindungsgemäß alle für die Herstellung von Magneten geeigneten üblicherweise eingesetzten Materialien einsetzen. Vorzugsweise besteht das Material im wesentlichen aus SE-FE-B, wobei SE für mindestens ein Element der Seltenen Erden einschließlich Y steht.

Besonders bevorzugt wird als Material für den Magnetkörper eine Zusammensetzung von 8 bis 30 at.-% SE und 2 bis 28 at.-% Bor, wobei der Rest Fe ist, eingesetzt.

Die nachfolgenden Ausführungsbeispiele dienen zur Erläuterung der Erfindung.

### Beispiel 1

Durch Sintern wurden 6 kg Stabmagnete aus Nd-Fe-B hergestellt und auf die Maße 20 x 6 x 2 mm geschliffen. Die Stabmagnete wurden in eine 7 1 fassende Galvanisierungstrommel gegeben und bei einer Umdrehungszahl von 15 U/min für eine Dauer von 60 s in einer 10%igen Salpetersäure gebeizt. Anschließend erfolgte eine dreimalige Spülung der Magnete mit Leitungswasser, danach eine zweimalige Spülung mit entionisiertem Wasser.

Nach der Spülung wurden die Teile 3 mal zur Passivierung der Oberfläche in γ-Butyrolacton gespült. Dabei wird das Wasser der Substanz zur Passivierung vollständig entfernt, um so eine Korrosion der Teile beim Trocknen zu verhindern.
Die Trocknung erfolgte direkt aus dem mit Lösungsmittel benetzten Zustand in einer Zentrifuge bei einer Temperatur von 80°C und einer Umdrehungszahl von 500 U/min. Die erhaltenen Magnetteile wiesen keinerlei Staub oder Rost an der Oberfläche auf.

Schließlich wurden die Magnetteile in einer IVD-Kammer im Trommelverfahren mit Aluminium beschichtet. Nach der Beschichtung wurde eine Schichtdicke von 5 bis 15 µm erhalten. Die aufgebrachte Aluminiumschicht wurde im letzten Schritt mit Hilfe von Glasperlenstrahlen verdichtet.

10 der gemäß vorliegendem Beispiel hergestellten Magnetteile wurden einer gesättigten Dampfatmosphäre mit einer Temperatur von 130°C und einem Druck von 2,7 bar für 72 Stunden ausgesetzt (HAST-Test). Anschließend wurden die Magnetteile visuell begutachtet.

Keines der 10 Magnetteile wies eine flächige Schichtablösungen bzw. Delaminationen auf.

### Beispiel 2

Die Herstellung der Aluminiumschicht wurde entsprechend Beispiel 1 durchgeführt mit folgenden Unterschieden: Nach der Spülung mit Wasser wurden die Teile unmittelbar anschließend in einem Dewatering Fluid, z. B. ®Safecoat, Fa. Castrol, getaucht, wodurch das auf den Teilen befindliche Wasser verdrängt wird. Die mit dem Dewatering Fluid benetzten Magnetteile wurden dann entsprechend Beispiel 1 getrocknet und mit einer Aluminiumschicht versehen.

Entsprechend Beispiel 1 wurden 10 dieser Magnetteile dem HAST-Test unterzogen und danach visuell begutachtet.

Keines der 10 Magnetteile wies flächige Schichtablösungen bzw. Delaminationen auf.

### Beispiel 3

Die Herstellung der Magnetteile erfolgte gemäß Anspruch 1 mit folgenden Unterschieden: Nach der Wasserspülung wurden die Teile unmittelbar anschließend in eine wässrige Lösung enthaltend eine handelsüblichen Chromsäure (Gelbchromatierung Typ ®Citrin 106, Fa. Kampschulte, 60 Sekunden lang getaucht. Danach wurden die Teile 3 x mit Leitungswasser und 2 x mit entionisierten Wasser gespült.

Entsprechend der Beispiele 1 und 2 wurden 10 dieser Magnetteile dem HAST-Test unterzogen und danach visuell begutachtet.

Keines der 10 Magnetteile wies flächige Schichtablösungen bzw. Delaminationen auf.

### Beispiel 4 (Vergleich)

6 kg Stabmagnete aus Nd-Fe-B wurden durch Korundstrahlen oberflächenaktiviert. Im Anschluß daran erfolgte eine Anblasung der Magnetteile mit ölfreier Pressluft. Im Gegensatz zu den vorangegangenen Beispielen wurden die Teile unmittelbar nach der Oberflächenaktivierung, d. h. innerhalb von 30 Minuten, in die Beschichtungskammer der IVD-Anlage eingebracht und beschichtet.

Entsprechend der Beispiele 1 bis 3 wurden 10 dieser Magnetteile dem HAST-Test unterzogen und danach visuell begutachtet.

Von den gemäß Beispiel 4 hergestellten 10 Magnetteilen wiesen 3 eine vollständige Schichtablösungen bzw. Delaminationen bereits nach 24 Stunden auf. Bei den restlichen 7 zeigte sich vollständige Schichtablösungen bzw. Delaminationen bereits nach 48 Stunden.

### Beispiel 5

10 der gemäß Beispiel 1 hergestellten Magnetteile wurden nach der Beschichtung gemäß dem in der EP-A-0 794 268 beschriebenen Verfahren 2 Stunden bei einer Temperatur von 500°C an Luft nachbehandelt.

Nach diesem Verfahren hergestellte Magnete weisen eine Korrosionsbeständigkeit, gemessen nach dem HAST-Test bei 130°C und einem Druck von 2,7 bar, von 150 Stunden auf.

Die Ausführungsbeispiele zeigen, daß die erfindungsgemäß hergestellten Magnetteile (Beispiele 1 bis 3) den HAST-Test für eine Dauer von mindestens 72 h bestehen. Durch thermische Nachbehandlung läßt sich die Korrosionsbeständigkeit der Magnetteile gemessen nach dem HAST-Test auf mindestens 150 Stunden erhöhen. Gemäß dem Stand der Technik hergestellte Magnetteile (Beispiel 4) erfüllen diese Anforderungen nicht.

## Patentansprüche

1. Verfahren zur Herstellung eines Sintermaterials mit verbessertem Korrosionsschutz durch Aktivierung der Oberfläche und anschließende Beschichtung der Oberfläche mit einem Metall und daran anschließender Wärmebehandlung,
**dadurch gekennzeichnet,**
**daß** während der Aktivierung vor Beschichtung der Oberfläche die Schritte
- Entfernung von auf der Oberfläche des Sintermaterials anhaftender Partikel mittels Behandlung der Oberfläche mit einem Beizmittel,
- Passivierung der Oberfläche durch mindestens einen der Schritte aus der Gruppe a) Behandlung mit einem hydrophilen Lösungsmittel, b) Behandlung mit einer Phosphatierungslösung, c) Behandlung mit einer Chromatierungslösung, d) Behandlung mit einer Flüssigkeit zur Dehydratisierung (Dewatering) der Oberfläche oder e) Temperaturbehandlung des Sintermaterials und
- Trocknung des Sintermaterials
durchgeführt werden.

2. Verfahren nach Anspruch 1,
**dadurch gekennzeichnet,**
**daß** das Sintermaterial vor der Beschichtung nicht mit einer Einrichtung zur mechanischen Strahlerrosion, wie Sandstrahlen oder Korundstrahlen, von Verunreinigungen gereinigt wird.

3. Verfahren nach Anspruch 1 oder 2,
**dadurch gekennzeichnet,**
**daß** das Beizmittel eine Säure enthält.

4. Verfahren nach mindestens einem der Ansprüche 1 bis 3,
**dadurch gekennzeichnet,**
**daß** das Beizmittel in wässriger Lösung vorliegt.

5. Verfahren nach mindestns einem der Ansprüche 1 bis 4,
**dadurch gekennzeichnet,**
**daß** das Beizmittel eine Lösung mit einem Säureanteil in einem Bereich von 0,2 bis 25 Gew.-% ist.

6. Verfahren nach mindestens einem der Ansprüche 1 bis 5,
**dadurch gekennzeichnet,**
**daß** das Mittel zum Beizen in wässriger Lösung vorliegt und
**daß** die Passivierung des Sintermaterials mittels einer Chromatlösung, einem Dewateringfluid oder einem wassermischbaren Lösungsmittel erfolgt.

7. Verfahren nach mindestens einem der Ansprüche 1 bis 6,
**dadurch gekennzeichnet,**
**daß** die auf die Oberfläche aufgebrachte Metallschicht zu mindestens 75 Gew.-% aus Al besteht.

8. Verfahren nach mindestens einem der Ansprüche 1 bis 7,
**dadurch gekennzeichnet,**
**daß** die Metallschicht nach einem physikalischen-Dampf-Abscheidungsverfahren (PVD) aufgebracht wird.

9. Verfahren nach mindestens einem der Ansprüche 1 bis 8,
**dadurch gekennzeichnet,**
**daß** die aufgebrachte Metallschicht durch Glasperlenstrahlen verdichtet wird.

10. Verfahren nach mindestens einem der Ansprüche 1 bis 9,
**dadurch gekennzeichnet,**
**daß** im Anschluß an die Beschichtung eine Wärmebehandlung oberhalb einer Temperatur von 400°C für eine Dauer von mindestens 30 Minuten durchgeführt wird.

## Claims

1. Method for the production of a sintered material with improved corrosion protection by activating the surface and then coating the surface with a metal, followed by heat treatment, **characterised in that** the following steps are carried out during the activation and before the coating of the surface:
- removal of particles adhering to the surface of the sintered material by treating the surface with a pickling agent,
- passivation of the surface by at least one of the steps from the group a) treatment with a hydrophilic solvent, b) treatment with a phosphating solution, c) treatment with a chromating solution, d) treatment with a liquid for dehydrating (dewatering) the surface or e) heat treatment of the sintered material, and
- drying of the sintered material.

2. Method according to claim 1, **characterised in that** the sintered material is not freed of impurities by means of a device for mechanical abrasion, such as sandblasting or corundum blasting, before the coating operation.

3. Method according to claim 1 or claim 2, **characterised in that** the pickling agent contains an acid.

4. Method according to at least one of claims 1 to 3, **characterised in that** the pickling agent is present in an aqueous solution.

5. Method according to at least one of claims 1 to 4, **characterised in that** the pickling agent is a solution with an acid content in the range of 0.2 to 25 % by weight.

6. Method according to at least one of claims 1 to 5, **characterised in that** the pickling agent is present in an aqueous solution and that the sintered material is passivated by means of a chromate solution, a dewatering fluid or a water-miscible solvent.

7. Method according to at least one of claims 1 to 6, **characterised in that** the metal layer applied to the surface consists of at least 75 % by weight Al.

8. Method according to at least one of claims 1 to 7, **characterised in that** the metal layer is applied by physical vapour deposition (PVD).

9. Method according to at least one of claims 1 to 8, **characterised in that** the metal layer applied is compacted by glass-bead blasting.

10. Method according to at least one of claims 1 to 9, **characterised in that** heat treatment is carried out at a temperature in excess of 400°C for a period of at least 30 minutes after the coating operation.

## Revendications

1. Procédé pour la fabrication d'une matière frittée possédant une protection anti-corrosion améliorée, par activation de la surface et enduction consécutive avec un métal et traitement thermique consécutif,
**caractérisé en ce que**
pendant l'activation avant l'enduction de la surface, s'effectue les étapes suivantes
- élimination de particules adhérant à la surface de la matière frittée au moyen d'un traitement de la surface avec un agent d'attaque,
- passivation de surface par au moins une des étapes tirées du groupe a) traitement avec un solvant hydrophile, b) traitement avec une solution de phosphatation, c) traitement avec une solution de chromatation, d) traitement avec un liquide pour la déshydratation (dewartering) de la surface ou e) traitement à la température de la matière frittée et
- séchage de la matière frittée.

2. Procédé selon la revendication 1,
**caractérisé en ce que**
avant l'enduction; la matière frittée n'est pas nettoyée des impuretés avec un dispositif d'érosion mécanique par jet et le sablage ou le projection de corindon.

3. Procédé selon la revendication 1 ou 2,
**caractérisé en ce que**
l'agent d'attaque contient un acide.

4. Procédé selon au moins une des revendications 1 à 3,
**caractérisé en ce que**
l'agent d'attaque est présent en solution aqueuse.

5. Procédé selon au moins une des revendications 1 à 4,
**caractérisé en ce que**
l'agent d'attaque est une solution contenant une proportion d'acide dans une plage de 0,2 à 25 % en poids.

6. Procédé selon au moins une des revendications 1 à 5,
**caractérisé en ce que**
l'agent d'attaque est présent en solution aqueuse et la passivation de la matière frittée s'effectue au moyen d'une solution de chromate, au moyen d'une fluide de dewatering ou un solvant missible avec l'eau.

7. Procédé selon au moins une des revendications 1 à 6,
**caractérisé en ce que**
la couche métallique appliquée sur la surface est composée de Al pour au moins 75 % en poids.

8. Procédé selon au moins une des revendications 1 à 7,
**caractérisé en ce que**
la couche métallique est appliquée après un procédé physique de dépôt en phase vapeur (PVD).

9. Procédé selon au moins une des revendications 1 à 8,
**caractérisé en ce que**
la couche métallique déposée est comprimée par une projection de perles de verre.

10. Procédé selon au moins une des revendications 1 à 9,
**caractérisé en ce que**
à la suite de l'enduction, on exécute un traitement thermique à une température supérieure à 400 °C pendant une durée d'au moins 30 minutes.
